# EUROPEAN PATENT SPECIFICATION

(11) **EP 2 140 498 B1**
(45) Date of publication and mention of the grant of the patent: **04.04.2018**
(21) Application number: 08737010.2
(22) Date of filing: 17.04.2008
(51) Int. Cl.: H01L 31/0336, H01L 31/032, H01L 31/18

(54) **FABRICATION OF ELECTRICALLY ACTIVE FILMS BASED ON MULTIPLE LAYERS**
HERSTELLUNG VON ELEKTRISCH AKTIVEN FILMEN AUF DER BASIS VON MEHREREN SCHICHTEN
FABRICATION DE FILMS ACTIFS ÉLECTRIQUEMENT À MULTIPLES COUCHES

(30) Priority: 18.04.2007 US 923984 P; 30.11.2007 US 991510 P; 01.12.2007 GB 0723539
(43) Date of publication of application: 06.01.2010
(73) Proprietor: Nanoco Technologies Limited, Manchester M13 9NT (GB)
(72) Inventor: PICKETT, Nigel, London CR0 6JQ (GB); HARRIS, James, Manchester M14 6ZY (GB)
(74) Representative: Dauncey, Mark Peter
(86) International application number: PCT/GB2008/001349
(87) International publication number: WO 2008/129250

(56) References cited:
- WO-A-2006/073437
- WO-A-2006/101986
- US-A1- 2005 183 767
- EBERSPACHER C ET AL: "Thin-film CIS alloy PV materials fabricated using non-vacuum, particles-based techniques", THIN SOLID FILMS, ELSEVIER-SEQUOIA S.A. LAUSANNE, CH, vol. 387, no. 1-2, 29 May 2001 (2001-05-29), pages 18-22, XP004232900, ISSN: 0040-6090, DOI: 10.1016/S0040-6090(00)01729-6

## Description

The present invention relates to thin-film materials, their fabrication, and devices made therefrom; and in particular to graded and multi-junction thin-film semiconductor structures.

Thin-film technologies are currently being developed for the purpose of reducing the cost of semiconductor devices, in particular photovoltaic (PV) cells. Whereas conventional solar cells are made of slices of solid crystalline silicon wafers, which have thicknesses of typically a few hundred microns, thin-film materials can be directly deposited onto a substrate to form layers of ∼2 µm or less, resulting in lower material as well as lower manufacturing costs. Moreover, thin-film technologies allow for monolithic integration, i.e. the *in situ* creation of electrical connections, which further reduces production costs.

Thin-film materials include cadmium-telluride (CdTe), copper indium diselenide (CIS) and variants thereof, amorphous silicon, and polycrystalline silicon (<50 µm). In recent years, technical progress has occurred particularly in thin-film technologies based on CdTe and CIS. Both materials have high absorptivities, so that most of the incident radiation can be absorbed within 1-2 *µ*m of the film. Used as the absorber layer, in which incoming photons create electron-hole pairs, these materials can be paired with, for instance, a layer of CdS, to form heterojunctions, and sandwiched between front and back contacts to form a solar cell.

To gain widespread acceptance, thin-film PV cells must exhibit high conversion efficiencies of photon energy to electric current, and operate reliably in an outdoor environment over many years, ideally no less than 30 years. Technologies based on CdTe and CIS have demonstrated long-term stability; however, performance degradation has also been observed. Efficiencies of current thin-film devices reach 65% of the theoretical maximum (75% in the laboratory), still lagging behind some monocrystalline silicon and GaAs cells, which have demonstrated 90% of their ultimate achievable performance. Improvements in efficiency of thin-film technologies can be achieved through multijunctions and graded materials. For example, studies on CIS have revealed that doping with gallium, to form compounds referred to as CIGS and exhibiting gradients in the concentrations of Ga and In, lead to better efficiencies.

The complexities of thin-film technologies, which are essential for high efficiencies, adversely affect cost and manufacturability, establishing a need for improved techniques - in particular low-cost techniques amenable to practice with off-the-shelf equipment. Challenges to the development of low-cost and reliable CIGS and CdTe devices include the standardization of equipment for layer deposition, absorber layers having thicknesses less than 1 µm, and control of film uniformity over large areas.

WO2006/101986 relates to the formation of nanoparticles and more particularly to formation of photovoltaic cells using nanoparticle inks for the fabrication of IB-IIIA-VIA absorber layers, where the absorber layers have a graded bandgap. US2005/0183767 relates to photovoltaic cells and more particularly to fabrication of IB-IIIA-VIA active layers for such cells. Thin-film CIS alloy PV materials fabricated using non-vacuum, particles-based techniques, Eberspacher, C., Fredric, C., Pauls, K., and Serra, J., Thin Solid Films 387 (2001) 18-22 relates to non-vacuum processing of sub-micron particles in which the elements which comprise the particles are present in carefully controlled ratios.

The present invention provides a method for fabricating a continuous film by successively printing and annealing two or more dispersions of prefabricated nanoparticles. In particular, the invention facilitates manufacture of graded and multijunction semiconductor films, which can be used in PV cells and other semiconductor devices. Since the method requires no vacuum, it is cheaper and more conveniently practiced than vacuum-based techniques.

Nanoparticles referred to herein are particles of specified elemental composition and no more than 100 nm, and preferably no more than 20 nm, in diameter. Typical nanoparticles include metal-oxide particles, which collectively form a powder. Some nanoparticle compositions suitable for semiconductor thin films comprise two or more of the chemical elements Cu, Ag, In, Ga, Al, Te, Se, S, Cd, and As. It should be stressed, however, that the method of the present invention utilises nanoparticles having the formula Culn₁₋ₓGaₓSe₂, where 0 ≤ x ≤ 1. One of the advantages of techniques in accordance with the present invention lies in the ability to optimize the composition of the thin film by providing compositional control over the precursor nanoparticles. This facilitates the fabrication of a continuous film comprised of layers of specified chemical composition, which allows for the compositional optimization of these layers, and, as a result thereof, for improved control over the electric characteristics of the film and, in particular, over the variation of these characteristics throughout the thickness of the film.

Dispersions according to the invention include any (homogeneous) mixture of nanoparticles and a suitable flowable carrier comprising solvents or dispersing agents, whether the mixture is a solution, a colloid, or a suspension. These dispersions of nanoparticles are termed "printing compositions" or "nanoparticle-based inks" herein.

Methods according to the invention can be implemented using a variety of printing techniques and the corresponding printing equipment, including, but not limited to, techniques such as inkjet printing, pneumatic spray printing, screen printing, pad printing, laser printing, dot matrix printing, thermal printing lithography, or 3D printing. This versatility contributes to feasibility and cost-effectiveness. Furthermore, the composition of the nanoparticles varies through the various deposition and annealing steps. For example, in the present invention, the different printable compositions comprise nanoparticles of the same elements in different proportions, the nanoparticles having the formula Culn₁₋ₓGaₓSe₂, wherein x varies between 0 and 1 (i.e. 0 ≤ x ≤ 1), resulting in a concentration gradient of at least one element (in the example In and Ga) through the film.

Accordingly, the invention provides a method of fabricating a film, which includes the steps of providing a substrate and a plurality of flowable printing compositions each comprising a different dispersion of prefabricated nanoparticles having the formula Culn₁₋ₓGaₓSe₂ where 0 ≤ x ≤ 1 and having an average size no greater than 100nm, and printing a layer of one of the printing compositions onto the substrate and annealing the printed layer to form a continuous film and repeating the printing and annealing steps with another or the same printing composition to form the film, wherein x varies through the printing compositions and wherein the nanoparticles of each composition comprise the same elements in different proportions, the layers being applied to create a concentration gradient of at least one element through the film. In some embodiments, two or more layers are successively printed before they are annealed. Further, in some embodiments an etching step precedes annealing. Some of the individual printed layers may have thicknesses smaller than 1 µm.

The printing compositions contain nanoparticles composed of the same elements in different proportions, so that the annealed layers form a film with a concentration gradient of at least one element through the film. In preferred embodiments, the nanoparticles have a size no greater than 20 nm and a low size dispersity.

In some embodiments, the film includes a semiconductor material and interacts electrically with the substrate. Moreover, this structure can be complemented by an electrically conductive superstrate to form a semiconductor device. In a particular embodiment, the device is a solar cell.

The foregoing discussion will be understood more readily from the following detailed description of the invention when taken in conjunction with the accompanying drawings.
FIG. 1 is a flow diagram detailing the steps of a method to manufacture a film by successive printing and annealing.
FIG. 2 schematically depicts a system and method for manufacturing the film in accordance with the present invention.
FIG. 3A is a schematic elevational view of a representative solar cell manufactured in accordance with the method of the present invention.
FIG. 3B is a schematic elevational view of a graded CIGS film, manufactured by first depositing all constituting layers and then annealing once to produce a continuous film, and of a solar cell made therefrom.

### 1. Fabrication method

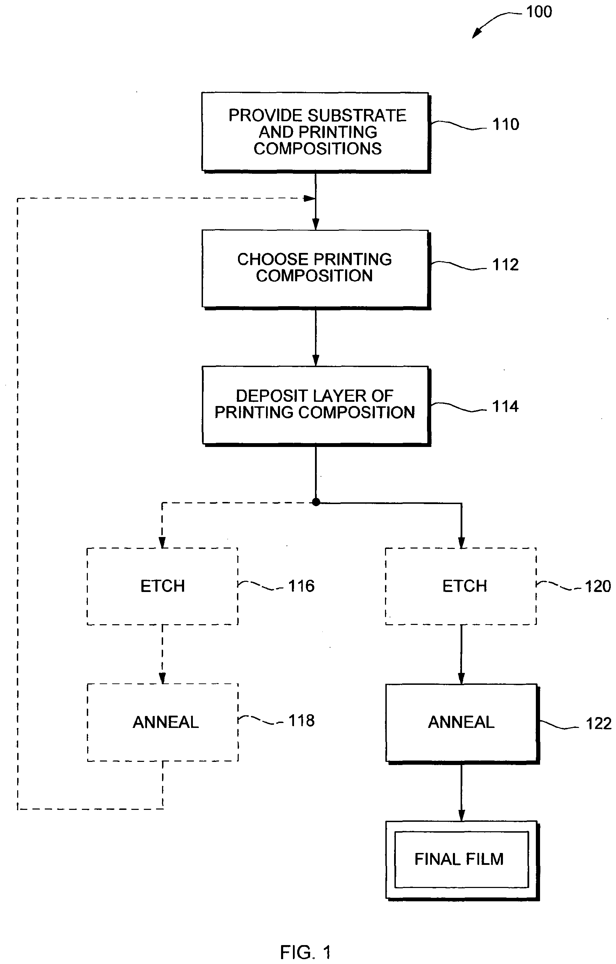

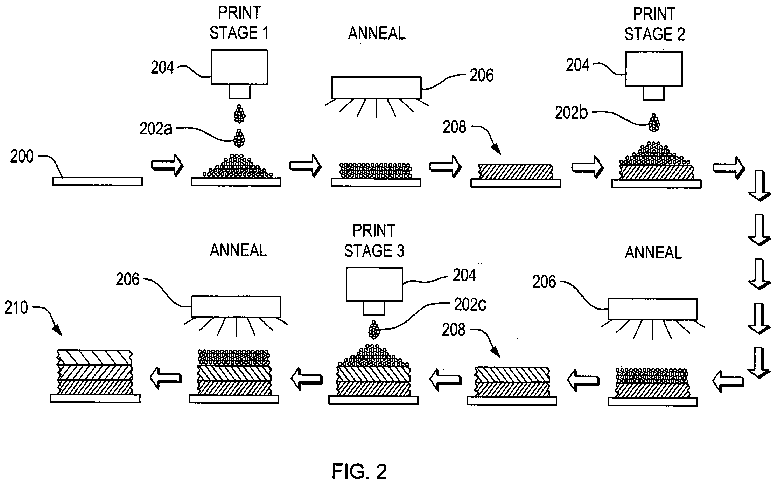

Refer first to FIGS. 1 and 2, which illustrate, respectively, a representative process sequence 100 and operative equipment implementing the present invention. The process sequence comprises the steps detailed in the flow diagram of FIG. **1****,** utilizing the equipment and resulting in the intermediate and final structures illustrated in **FIG. 2****.** In a first step **110,** a substrate **200** and a plurality of flowable printing compositions comprising different dispersions of prefabricated nanoparticles, as further described below, are provided. A printing composition **202a** is selected for the first layer in step **112,** and in step **114,** this composition is printed onto the substrate **200** using a printer **204.** In some cases, which will be described below, an etch step **116** is performed after printing. In an optional step **118,** the deposited layer is dried and annealed using a heat source **206** to form a continuous film **208.** By "annealing" is meant heating of a deposited layer at a sufficient temperature and for a sufficient time that the nanoparticles fuse into a continuous layer of uniform composition. Whether annealing is performed after deposition of a particular layer depends on the specifics of the printing composition, the layer thickness, and desired film characteristics. In general, however, the composition will be dried before a subsequent composition is deposited thereon. Annealing source **206** may be any suitable heat source, e.g., an oven, vacuum oven, furnace, IR lamp, laser, or hot plate, and suitable annealing times and temperatures, which depend on nanoparticle size and composition as well as ink composition, may be obtained without undue experimentation by means of calibration as described below in the context of printing equipment. Anneal temperatures are generally above 200 °C.

The steps **112, 114,** and optionally steps **116, 118,** are repeated to print a second printing composition **202b,** which generally differs from the composition **202a,** resulting in a film **208** that now contains two layers. This repetition may involve the same printing and annealing equipment **204, 206,** in which case the new printing composition is substituted (e.g., in the form of a cartridge) in printer **204.** Alternatively, the process sequence **100** may be carried out in a assembly-line configuration with separate printing and annealing equipment dedicated to each deposition and annealing step. Utilizing the same equipment for multiple steps may be more practical where numerous films are fabricated in parallel (i.e., the same steps are simultaneously performed on multiple substrates); while a line configuration may be preferred where individual substrates **200** are processed serially.

Steps 110-118 may (but need not) be repeated a plurality of times to form a film having three or more layers 202a, 202b, 202c. Once again, a particular printing composition can be utilized once or more than once, although in the case of graded films, the composition will change progressively with each deposition step. After the last layer has been printed, an etching step 120 is again optional, but a final annealing step 122 must take place, whether previous anneals 116 have been performed or not, to form a continuous final film 210 from the deposited layers. The number of layers deposited and annealed in this way is at least two, and is limited only by the desired thickness and composition of the final film 210. Accordingly, while FIG. 2 illustrates the manufacturing of a film with three layers, this is merely for illustration.

Each layer contains a single type of nanoparticle, in which case different layers typically contain nanoparticles having different chemical compositions. The method 100 is employed to produce a high-efficiency graded film by using a variety of printing compositions with nanoparticles comprising the same elements, but in different proportions. For example, a CIGS film may be produced with the varying chemical composition Culn₁₋ₓGaₓSe₂, where x varies progressively among successively deposited layers (i.e., successive printing compositions). For example, x may be the distance of a certain location within the film from a boundary surface of the film (e.g., the top surface of the structure or the boundary surface in contact with the substrate), divided by the thickness of the film. Such films have been manufactured by means of chemical vapor deposition (CVD) and used as the absorption layer in a PV cell with the gallium concentration increasing towards a molybdenum back contact, resulting in a particularly high efficiency of 19.5% - a consequence of reduced back-surface recombination due to the quasi-electric field established by the concentration and corresponding bandgap gradient. The method 100 provides an alternative to the CVD process: using a suitable substrate, such as Mo- covered glass, CulnSe₂ may be deposited for the first layer, followed by printing
compositions in which the Ga content is progressively (in a linear or nonlinear fashion) increased in each layer, until the composition of the nanoparticles is primarily CuGaSe₂. Once the layers are printed in the desired sequence, they are annealed to form a high-performance graded CIGS film. Other nanoparticle-based inks may also be introduced as intermediate layers to further tune the band structure of the material in order to optimize the performance of the cell. Techniques in accordance with the present invention offer the additional advantage, compared with CVD, of avoiding the need for vacuum equipment.

### 2. Printing Equipment 204

For the implementation of the printing step 114, a variety of well-characterized printing processes can be used to advantage, including, but not limited to, inkjet printing, pneumatic spraying, screen printing, pad printing, laser printing, dot matrix printing, thermal printing, lithography, and 3D printing. Computer-controlled inkjet printers are readily available and particularly attractive for practice of the invention because of the level of control they provide. A commercially available inkjet printer can be used with little or no modification to print nanoparticle-based inks (the printing compositions) as described herein. To avoid problems such as clogging of the printer head or other incompatibilities, the viscosities of nanoparticle-based inks can be adjusted to those of inks produced by the printer's manufacturer, as detailed below in the context of printing compositions. The amenability of the method 100 to readily available, low-cost equipment, such as inkjet printers, constitutes one of its advantages.

To facilitate control over the thicknesses of the individual layers and the film as a whole, the printer can be calibrated as follows. For each printing composition, a sequence of print runs is carried out, each print run involving a different number of printing passes. Drying and annealing are performed after each printing pass or at the end of a run. The thickness of the film resulting from each of the runs is different, and is determined via scanning electron microscopy (SEM) or transmission electron microscopy (TEM), or any other suitable technique. As a result, a layer having a desired thickness may be made by reference to the number of printing passes corresponding to that thickness. Similar calibration techniques can be used to determine optimal annealing temperatures and times for desired film properties.

### 3. Printing compositions 202

Printing compositions in accordance herewith are flowable dispersions of nanoparticles. Particulate precursor materials simplify compositional control for multicomponent materials such as, for example, CIGS, since key components (e.g., Cu, In, Ga) can be precisely mixed in the precursor powders. One method of fabricating these powders involves mixing the constituent elements at the required ratios, dissolving them in acid to form an aqueous mixture, using hydroxide precipitation to form a gelatinous mixture of hydroxides of the elements, and drying the mixture to obtain a fine powder of mixed oxides. Nanoparticle synthesis can also be carried out using techniques described, for example, in U.S. Patent No. 6,379,635 and co-pending U.S. Patent Nos. US7803423 and US7867556.

Methods for preparing CdSe, InS, GaS, ZnS, CdS, ZnAs, CdAs and further related nanocrystalline materials are described in Sections 1. to 10. of the experimental section of US Patent No. 6,379,635. This describes how nanocrystal precursors can be provided in a single precursor complex (such as, but not limited to an alkyl carbonate complex of the required metal ions), which is then thermally decomposed under suitable conditions (e.g. temperatures of around 200 to 300°C) to yield the final desired nanocrystalline material.

By way of example, nanocrystalline CdSe can be formed as follows, 1.2 MeCddsc (0.5 mmol) was placed in 10 ml of TOP (98 %, Aldrich) and the mixture formed was filtered after which was injected in 30 g of TOPO at 200°C. The temperature of the
solution was then raised to 250°C and heated for half an hour. The deep red solution that formed was allowed to cool down to 75°C after which a large excess of dry CH₃OH (BDH) was added. A flocculate precipitate formed and was isolated by centrifugation and redispersed in toluene, any insoluble material was then discarded. The toluene was pumped off under vacuum (10⁻² Torr) to give a deep red material which was washed with CH₃OH. The solid was redispersed in toluene to give solutions with a Port wine red colour which remained optically clear for weeks. Size selective precipitation was performed by adding CH₃OH to this solution until turbidity was observed followed by centrifugation. This procedure was successively applied to the supernatant solutions obtained during the fractionation process until no optical absorption was detected.

Similar methods can be employed to produce III-VI nanocrystalline materials (e.g. InS, GaS) by replacing MeCddsc with a complex of the general formula, (AlK1)₂M^{III}E₂CN(AlK2)₂, where AIK1 and A1K2 are individually alkyl groups, such as Me,Et,Np etc, each AIK1 and AIK2 being the same or different, M^{III} is a group III metal ion such as In, Ga etc, and E is a group VI ion, such as S,Se etc; and to produce II-VI or II-V nanocrystalline materials (e.g. ZnS, CdS, ZnAs and CdAs) by replacing MeCddsc with a complex of the general formula [MI[E₂CN(AlK3)₂]₂], where each AIK3 is an alkyl group, such as Me,Et,Pr etc, each AIK3 being the same or different, M^{II} is a group II metal ion, such as Zn, Cd etc, and E is a group V or VI ion, such as As or S,Se etc.

Methods for preparing large amounts of nanocrystalline materials are described in US Patent Nos. US7803423 and US7867556. These patents describe for the first time how molecular clusters can be used to seed controlled growth of any desirable nanocrystalline material, which can then be provided with one or more outer shells of a different material to the material forming the nanocrystal core grown on the molecular cluster seed.

By way of example, US Patent No. US57803423 describes in Examples 1 to 9, the preparation of the clusters [HNEt₃]₂[Cd₄(SPh)₁₀] and [HNEt₃]₄[Cd₁₀ Se₄(SPh)₁₆] which can then be used to produce CdSe nanocrystals by controlled addition
of Cd ions and Se ions (from, e.g. TOPSe and Cd(CH₃CO₂)₂) over a suitable time period, in combination with suitably controlled increases in the temperature of the reaction mixture. For example, Example 1 describes the preparation of CdSe nanoparticles from [Et₃NH]₄[Cd₁₀Se₄(SPh)₁₆] / TOPSe / Cd(CH₃CO₂)₂ in HDA. HDA (300g) was placed in a three-neck flask and dried/degassed by heating to 120°C under a dynamic vacuum for 1 hour. The solution was then cooled to 70°C. To this was added 1.0g of [Et₃NH]₄[Cd₁₀Se₄(SPh)₁₆] (0.311mmol), TOPSe (20ml, 40.00mmol) [previously prepared from dissolving selenium powder in TOP] and Cd(CH₃CO₂)₂ (10.66g 40.00mmol) the temperature of reaction mixture was gradually increased from 70°C to 180°C over an 8 hour period. The progressive formation/growth of the nanoparticles was monitored by their emission wavelength by taking aliquots from the reaction mixture and measuring their UV-vis and PL spectra. The reaction was stopped when the emission spectra had reached 572nm by cooling the reaction to 60°C followed by addition of 200ml of dry "warm" ethanol which gave a precipitation of nanoparticles. The resulting CdSe were dried before re-dissolving in toluene filtering through Celite followed by re-precipitation from warm ethanol to remove any excess HDA and Cd(CH₃CO₂)₂. This produced 9.26g of HDA capped CdSe nanoparticles.

By way of further example, US Patent No. US7867556 describes the preparation of CdSe nanoparticles from [HNEt₃]₄[Cd₁₀Se₄(SPh)₁₆]/TOPSe/Me₂CdTOP in HDA by dropwise addition of Me₂CdTOP, and the preparation of ZnS nanoparticles from [Et₃NH]₄Zn₁₀S₄(SPh)₁₆] seeds in HDA by dropwise addition of Et₂Zn and S-octylamine. Nanoparticles formed in this way can then be provided with one or more shell layers to provide CdSe/ZnS-HDA capped nanoparticles, and ZnSe/ZnS nanoparticles. For example ZnS nanoparticles can be formed from [Et₃NH]₄Zn₁₀S₄(SPh)₁₆] seeds in HDA by dropwise addition of Et₂Zn and S-octylamine as follows. A 200 g portion of hexadecylamine (HDA) was placed in a three-neck round-bottomed flask and dried and degassed by heating to 120°C under a dynamic vacuum for > 1 hour. The solution was cooled to 60°C, the reaction flask was filled with nitrogen and the following reagents were loaded into the flask using standard
airless techniques: 0.6 g [HNEt₃]₄[Zn₁₀S₄(SPh)₁₆] (0.2 mmol), 4 mL of a 0.5 M solution of Et₂Zn in trioctylphosphine (2 mmol), and 4 mL of a 0.5 M solution of elemental sulphur in octylamine (2 mmol). The temperature was increased to 120 °C and allowed to stir for 2 hours. At this point a programmed temperature ramp from 120 °C to 210 °C at a rate of ∼0.2°C/min was initiated. Simultaneously, 8 mL of 0.5 M Et₂Zn and 8 mL of 0.5 M S-octylamine were added dropwise at a rate of ∼0.05 mL/min. The reaction was stopped when the PL emission maximum had reached the required emission (λₘₐₓ = 391 nm, FWHM = 95 nm) by cooling to 60° C followed by addition to 300 ml of dry ethanol or acetone to precipitate the particles from solution. This precipitate was isolated by filtration. The resulting ZnS particles were further purified (to remove excess HDA, sulphur and zinc) by re-dissolving in toluene, filtering the solution through Celite and reprecipitating from warm ethanol (product yield: 0.9g). Capping or shelling of CdSe nanoparticles can then be carried out, for example, as follows HDA (800g) was placed in a three neck round-bottom flask, dried and degassed by heating to 120°C under a dynamic vacuum for > 1 hour. The solution was then cooled to 60°C, to this was added 9.23g of CdSe nanoparticles that have a PL maximum emission of 585nm. The HDA was then heated to 220°C. To this was added by alternate dropwise addition a total of 20ml of 0.5M Me₂Zn•TOP and 0.5M, 20ml of sulfur dissolved in octylamine. Three alternate additions of 3.5, 5.5 and 11.0ml of each were made, whereby initially 3.5ml of sulphur was added dropwise until the intensity of the PL maximum was near zero. Then 3.5ml of Me₂Zn•TOP was added dropwise until the intensity of the PL maximum had reached a maximum. This cycle was repeated with the PL maximum reaching a higher intensity with each cycle. On the last cycle, additional precursor was added once the PL maximum intensity been reached until it was between 5 - 10% below the maximum intensity, and the reaction was allowed to anneal at 150°C for 1 hour. The reaction mixture was then allowed to cool to 60 °C whereupon 300ml of dry "warm" ethanol was added which resulted in the precipitation of particles. The resulting CdSe-ZnS particles were dried before re-dissolving in toluene and filtering through Celite followed by re-precipitation from warm ethanol to remove any excess HDA. This produced 12.08g of HDA capped CdSe-ZnS core-shell nanoparticles. Elemental analysis C = 20.27, H =3.37, N = 1.25, Cd = 40.11, Zn = 4.43 %; Max PL 590nm, FWHM 36nm.

A method for producing CIGS nanoparticles of any desirable stoichiometry employing a selenol compound is disclosed in U.S. Provisional Application Serial No. 60/991,510. Embodiments of the method involve dispersing at least a first portion of a nanoparticle precursor composition (comprising sources of at least one of Al, Ga, and/or In, and at least one of Cu, Ag, Zn, and/or Cd) in a solvent (e.g., a long-chain hydrocarbon solvent); heating the solvent to a first temperature for an appropriate length of time; adding a selenol compound to the solvent and heating the solvent; adding a second portion of the nanoparticle precursor composition to the reaction mixture; heating the mixture to a second temperature higher than the first temperature over an appropriate length of time; and maintaining the temperature for up to 10 hours. Once the particles have been formed, the surface atoms of the particles will typically be coordinated to a capping agent, which can comprise the selenol compound employed in the method. If a volatile selenol compound is used, this capping agent can be driven off with heating to yield 'naked' nanoparticles amenable to capping with other coordinating ligands and further processing. Examples 1 and 2 provide further details regarding the implementation of this method:

Example 1: Cu(I) acetate (1 mmol) and In(III) acetate (1 mmol) are added to a clean and dry RB-flask. Octadecene ODE (5 mL) is added the reaction mixture heated at 100 °C under vacuum for 30 mins. The flask is back-filled with nitrogen and the temperature raised to 140 °C. 1-octane selenol is injected and the temperature falls to 120 °C. The resulting orange suspension is heated with stirring and a transparent orange/red solution is obtained when the temperature has reached 140°C. This temperature is maintained for 30 minutes, then 1M tri-octyl-phoshine selenide TOPSe (2mL, 2 mmol) is added dropwise and the solution heated at 160°C. The PL is monitored until it reaches the desired wavelength, after which it is cooled and the resulting oil washed with methanol/acetone (2:1) 4-5 times and finally isolated by precipitation with acetone.

Example 2 (Large Scale Production): A stock solution of TOPSe was prepared by dissolving Se powder (10.9, 138 mmol) in TOP (60 mL) under nitrogen. To dry, degassed ODE was added Cu(I) acetate (7.89 g, 64.4 mmol) and In(III) acetate (20.0 g, 68.5 mmol). The reaction vessel was evacuated and heated at 140°C for 10 min, backfilled with N₂ and cooled to room temp. 1-Octane selenol (200 mL) was added to produce a bright orange suspension. The temperature of the flask was raised to 140°C and acetic acid distilled from the reaction at 120°C. On reaching 140°C the TOPSe solution was added dropwise over the course of 1 hour. After 3 hours the temperature was raised to 160°C. The progress of the reaction was monitored by taking aliquots from the reaction periodically and measuring the UV/Visible and photoluminescence spectra. After 7 hours the reaction was cooled to room temperature and the resulting black oil washed with methanol. Methanol washing was continued until it was possible to precipitate a fine black material from the oil by addition of acetone. The black precipitate was isolated by centrifugation, washed with acetone and dried under vacuum. Yield: 31.97 g.

To optimize particle properties or the selection of suitable dispersants, the nanoparticles can be characterized with respect to their composition, size, and charge by conventional techniques including x-ray diffraction (XRD), UV/Vis/Near-IR spectrometry, scanning or transmission electron microscopy (SEM/TEM), energy dispersive x-ray microanalysis (EDAX), photoluminescence spectrometry, and/or elemental analysis. Inductively coupled plasma atomic-emission spectroscopy (ICPAES) analysis of representative Cu/In/Se core particles, prepared in a 1-octane selenol capping agent which was subsequently removed, provided the following suitable nanoparticle composition: Cu 16.6%; In 36.6 %; Se 48.3 %, corresponding to Cu_{1.00}, In_{1.22}, Se_{2.34}, and a Cu/In ratio of 0.82.

In preferred embodiments of the present invention, the nanoparticles have average sizes not greater than 20 nm, and low size dispersities of around ±2 nm or less. Conformance
to these constraints facilitates printing of thin films with control over the band structure through the film, resulting in high conversion efficiencies. Moreover, low size dispersities allow for good packing of the nanoparticles, and uniform melting temperature of the nanoparticle films, which contributes to proper film formation.

The nanoparticles are dispersed in a carrier comprising solvents, such as toluene, and dispersing agents to form the printing composition. The dispersion may take the form of a solution, colloid, or suspension, generally depending on the particle size, and may have the consistency of a liquid, paste, or other viscoelastic material, as long as it is flowable. Its viscosity should be within the range from 0.158 × 10¹¹ cP to 2.3 × 10¹¹ cP.

In embodiments in which water-based inks are formed with non-soluble nanoparticles, surface area and charge of the particles drive the selection of dispersants suitable for ink formulation. For example, in pigment-based inkjet printing, the overall charge the particles acquire (i.e., the zeta potential) in the medium in which they are dispersed should be sufficiently high to ensure dispersion stability; but excessive dispersion stability can result in flocculation and consequent clogging of the printer head. To ensure the jetting potential of the ink through the nozzle, the average agglomerate size should be minimized. In the printing industry, it is generally recognized that particle sizes of over 500 nm may cause plugging of the inkjet nozzles, compromising print quality.

To mitigate print-head blocking concerns, nanoparticles can be coated in water-solubilizing capping agents, such as a mercaptocarboxylic acid (e.g., mercaptoacetic acid). For example, U.S. Patent No. 6,114,038 teaches how to exchange the coating groups of water-insoluble, pyridine-capped nanocrystals with a large excess of neat mercaptocarboxylic acid to obtain water-soluble capped nanocrystals. In brief, the pyridine-capped nanocrystals are precipitated with hexanes and centrifuged; the residue is dissolved in neat mercaptoacetic acid and incubated at room temperature for at least six hours; chloroform is added to precipitate the nanocrystals and wash away excess thiol; and the nanocrystals are again centrifuged, washed with chloroform and hexane, and dried with argon. The viscosity of the printing composition (nanoparticle-based ink) is desirably adjusted to achieve plastic flow behavior, i.e., where viscosity is essentially independent of flow rate. This facilitates control over coating characteristics. Capping agents needed for solubilization or suspension can be removed to stop the formation of carbon deposits within the film. In some cases, this removal occurs naturally as a result of annealing at elevated temperatures, but if does not, it can be aided by a prior etching step 116, 120.

### 4. Applications

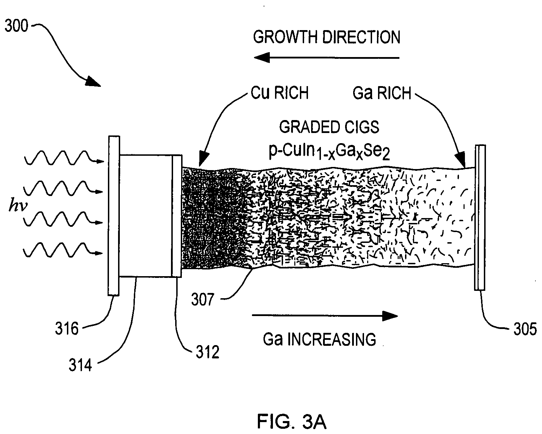

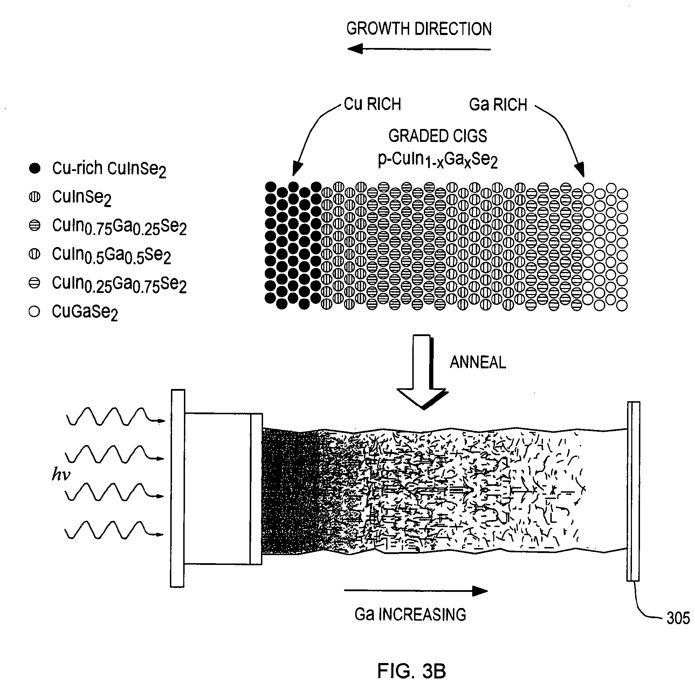

Semiconductor thin-film structures manufactured according to the method illustrated in FIG. 1 can be used in photovoltaic cells, LEDs, transistors, and other semiconductor devices. FIG. 3A illustrates a representative structure of a solar cell with a CIGS absorber film. The substrate 305 comprises molybdenum on glass, and the submicron Mo layer also provides the back contact of the cell 300. The absorber film 307 comprises a series of annealed layers of CIGS, and exhibits increasing Ga and decreasing In concentration towards the Mo contact 300. This film can be manufactured by printing and annealing each layer consecutively. Alternatively, as illustrated in FIG. 3B, which exemplifies the In and Ga contents of individual layers, it can be manufactured by first depositing all the layers, and subsequently fusing these layers into one continuous film in one annealing step. A buffer layer 312 forms the junction with the CIGS film. Conventionally, this junction comprises CdS. However, due to environmental and health concerns associated with Cd, preferred PV cells are cadmium-free, using ZnS, ZnO(O,OH), or In₂S₃ instead. Accordingly, a ZnO layer 314 over a glass cover 316 provides the superstrate of the cell 300. The performance of a ZnO/ZnO(O,OH)/CIGS/Mo cell can be improved or optimized by introducing layers of other semiconductor materials within the absorber film 307. CIGS variants (e.g., as shown in the following Table 1) in which Se is replaced by S or Te, Cu by Ag, or In or Ga by Al, for example, can be used to manipulate the energies of the valence and conduction bands to aid in electron-hole capture. If nanoparticle
sources are available for the junction layer and/or the substrate or superstrate, these layers can likewise be integrated into the device by printing and annealing, as long as none of the required annealing temperatures is detrimental to the other layers within the device.

**Table 1.**

| Low Bandgap Material | *E*_{g}(eV) | High Bandgap Material | *E*_{g}(eV) |
|---|---|---|---|
| CuInSe₂ | 1,0 | CuAlSe₂ | 2.71 |
| CuInTe₂ | 1.10-1.15 | CuInS₂ | 1.53 |
| CuGaTe₂ | 1,23 | CuAlTe₂ | 2,06 |
| | | CuGaSe₂ | 1.10 |
| | | CuGaS₂ | 2.50 |
| | | | |
| AgInSe₂ | 1.20 | AgGaSe₂ | 1.80 |
| AgGaTe₂ | 1.1-1.3 | AgAlSe₂ | 1,66 |
| AgAlTe₂ | 0.56 | AgInS₂ | 1.80 |
| | | AgGaSe₂ | 1.80 |
| | | AgGaS₂ | 2.55 |
| | | AgAlS₂ | 3.13 |

Although the present invention has been described with reference to specific details, it is not intended that such details should be regarded as limitations upon the scope of the invention, except as and to the extent that they are within the scope of the accompanying claims.

## Claims

1. A method of fabricating a film, the method comprising the steps of:
a. providing a substrate and a plurality of flowable printing compositions each comprising a different dispersion of prefabricated nanoparticles having the formula Culn₁₋ₓGaₓSe₂, where 0 ≤ x ≤ 1 and having an average size no greater than 100 nm;
b. printing a layer of one of the printing compositions onto the substrate;
c. annealing the printed layer to form a continuous film; and
d. repeating steps (b) and (c) with another or the same printing composition to form the film,
wherein x varies through the printing compositions and wherein the nanoparticles of each composition comprise the same elements in different proportions, the layers being applied to create a concentration gradient of indium and gallium through the film.

2. The method of claim 1, wherein at least some of the printed layers have a thickness smaller than 1 µm.

3. The method of claim 1 or 2 further comprising repeating step (b) at least once before step (c).

4. The method of claim 1, 2 or 3 further comprising the step of performing an etch after printing and before annealing.

5. The method of any one of claims 1 to 4 wherein the printing compositions are suspensions or solutions.

6. The method of any preceding claim wherein the printing step is performed by a printing technique selected from the group consisting of inkjet printing, pneumatic spraying, screen printing, pad printing, laser printing, dot matrix printing, thermal printing, lithography, or 3D printing.

7. The method of any preceding claim wherein the nanoparticles have a size no greater than 20 nm and a low size dispersity.

8. The method of any preceding claim wherein the thin film comprises a semiconductor and interacts electrically with the substrate, and the method further optionally comprises adding an electrically conductive superstrate and external contacts to produce a semiconductor device, said device preferably being a solar cell.

## Patentansprüche

1. Verfahren zur Herstellung eines Films, wobei das Verfahren folgende Schritte beinhaltet:
a. Bereitstellen eines Substrates und einer Vielzahl von strömbaren Druckzusammensetzungen, welche jeweils eine unterschiedliche Dispersion von vorgefertigten Nanopartikeln der Formel Culn₁₋ₓGaₓSe₂ enthalten, wobei 0 ≤ x ≤ 1, und welche eine durchschnittliche Größe von nicht über 100 nm besitzen;
b. Drucken einer Schicht einer der Druckzusammensetzungen auf dem Substrat;
c. Glühen der gedruckten Schicht zum Bilden eines kontinuierlichen Films; und
d. Wiederholen der Schritte (b) und (c) mit einer anderen oder derselben Druckzusammensetzung zum Bilden des Films,
wobei x durch die Druckzusammensetzungen variiert und wobei die Nanopartikel einer jeden Zusammensetzung dieselben Elemente in unterschiedlichen Proportionen enthalten, wobei die Schichten aufgetragen werden, um einen Konzentrationsgradienten von Indium und Gallium durch den Film zu bilden.

2. Verfahren nach Anspruch 1, bei welchem mindestens einige der gedruckten Schichten eine Dicke unter 1 µm besitzen.

3. Verfahren nach Anspruch 1 oder 2, zudem beinhaltend das Wiederholen von Schritt (b) mindestens einmal vor Schritt (c).

4. Verfahren nach Anspruch 1, 2 oder 3, zudem beinhaltend den Schritt der Durchführung einer Ätzung nach dem Drucken und vor dem Glühen.

5. Verfahren nach einem der Ansprüche 1 bis 4, bei welchem die Druckzusammensetzungen Suspensionen oder Lösungen sind.

6. Verfahren nach einem der vorhergehenden Ansprüche, bei welchem der Schritt des Druckens anhand einer Drucktechnik durchgeführt wird, gewählt aus der Gruppe, bestehend aus Tintenstrahldruck, pneumatischem Sprühen, Siebdruck, Tampondruck, Laserdruck, Punktrasterdruck, Thermodruck, Lithografie oder 3D-Druck.

7. Verfahren nach einem der vorhergehenden Ansprüche, bei welchem die Nanopartikel eine Größe nicht über 20 nm und eine geringe Größenstreuung besitzen.

8. Verfahren nach einem der vorhergehenden Ansprüche, bei welchem der dünne Film einen Halbleiter beinhaltet und elektrisch mit dem Substrat interagiert, und wobei das Verfahren zudem optionsweise das Hinzufügen einer elektrisch leitfähigen Superstrate und externer Kontakte beinhaltet, um eine Halbleitervorrichtung herzustellen, wobei diese Vorrichtung vorzugsweise eine Solarzelle ist.

## Revendications

1. Procédé de fabrication d'un film, le procédé comprenant les étapes consistant à :
a. fournir un substrat et une pluralité de compositions d'impression fluides comprenant chacune une dispersion différente de nanoparticules préfabriquées répondant à la formule Culn₁₋ₓGaₓSe₂, où 0 ≤ x ≤ 1 et ayant une taille moyenne ne dépassant pas 100 nm ;
b. imprimer une couche d'une des compositions d'impression sur le substrat ;
c. recuire la couche imprimée pour former un film continu ; et
d. répéter les étapes (b) et (c) avec une autre composition d'impression ou la même pour former le film,
dans lequel x varie avec les compositions d'impression et dans lequel les nanoparticules de chaque composition comprennent les mêmes éléments dans des proportions différentes, les couches étant appliquées pour créer un gradient de concentration de l'indium et du gallium à travers le film.

2. Procédé selon la revendication 1, dans lequel au moins une partie des couches imprimées ont une épaisseur inférieure à 1 µm.

3. Procédé selon la revendication 1 ou 2 comprenant en outre la répétition de l'étape (b) au moins une fois avant l'étape (c).

4. Procédé selon la revendication 1, 2 ou 3 comprenant en outre l'étape consistant à effectuer une gravure après l'impression et avant le recuit.

5. Procédé selon l'une quelconque des revendications 1 à 4, dans lequel les compositions d'impression sont des suspensions ou des solutions.

6. Procédé selon l'une quelconque des revendications précédentes, dans lequel l'étape d'impression est effectuée par une technique d'impression sélectionnée dans le groupe constitué par l'impression à jet d'encre, la pulvérisation pneumatique, la sérigraphie, l'impression au tampon, l'impression laser, l'impression à matrice de points, l'impression thermique, la lithographie ou l'impression 3D.

7. Procédé selon l'une quelconque des revendications précédentes, dans lequel les nanoparticules ont une taille ne dépassant pas 20 nm et un faible degré de dispersion des tailles.

8. Procédé selon l'une quelconque des revendications précédentes, dans lequel le film mince comprend un semi-conducteur et interagit électriquement avec le substrat, et le procédé comprend en outre facultativement l'addition d'une couche supérieure électriquement conductrice et de contacts externes pour produire un dispositif semi-conducteur, ledit dispositif étant de préférence une cellule solaire.
